**Europäisches Patentamt**

**European Patent Office**

**Office européen des brevets**

(19)

(11) Veröffentlichungsnummer : **0 352 446 B1**

## (12) EUROPÄISCHE PATENTSCHRIFT

(45) Veröffentlichungstag der Patentschrift :
**09.09.92 Patentblatt 92/37**

(51) Int. Cl.⁵ : **H03J 5/02**

(21) Anmeldenummer : **89110071.1**

(22) Anmeldetag : **03.06.89**

(54) **Anordnung zur Programmanwahl bei Empfangsgeräten der Unterhaltungselektronik.**

(30) Priorität : **27.07.88 DE 3825427**

(43) Veröffentlichungstag der Anmeldung :
**31.01.90 Patentblatt 90/05**

(45) Bekanntmachung des Hinweises auf die
Patenterteilung :
**09.09.92 Patentblatt 92/37**

(84) Benannte Vertragsstaaten :
**AT CH DE FR GB IT LI**

(56) Entgegenhaltungen :
**GB-A- 1 538 294**
**GB-A- 2 023 363**
**US-A- 3 943 451**

(73) Patentinhaber : **GRUNDIG E.M.V.**
**Elektro-Mechanische Versuchsanstalt Max**
**Grundig holländ. Stiftung & Co. KG.**
**Kurgartenstrasse 37**
**W-8510 Fürth/Bay. (DE)**

(72) Erfinder : **Fuchs, Hermann c/o Grundig E.M.V.**
**holländ. Stiftung & Co KG Kurgartenstrasse 37**
**W-8510 Fürth/Bay (DE)**

## Beschreibung

Die Erfindung betrifft eine Anordnung zur Programmanwahl bei Empfangsgeräten der Unterhaltungselektronik mit den im Oberbegriff des Patentanspruchs angegebenen Merkmalen.

Eine derartige Anordnung ist aus der DE-PS 34 04 976 bekannt. Bei der bekannten Anordnung ist ein Zeitglied vorgesehen, welches durch die Betätigung einer ersten Zifferntaste der Zehnertastatur eingeschaltet wird. Wird nun innerhalb des durch das Zeitglied vorgegebenen Zeitintervalles eine zweite Zifferntaste betätigt, so wird die erste Zirferntaste als Zehnerstelle und die zweite Zifferntaste als Einerstelle ausgewertet. Die Umschaltung auf das gewünschte Programm erfolgt unmittelbar nach Betätigung der zweiten Zifferntaste. Wird hingegen innerhalb des durch das Zeitglied vorgegebenen Zeitintervalls keine zweite Zifferntaste betätigt, so wird nach Beendigung des durch das Zeitglied vorgegebenen Zeitintervalls die erste Zifferntaste als Einerstelle ausgewertet. Die Umschaltung auf das gewünschte Programm erfolgt demzufolge erst nach Ablauf des genannten Zeitintervalles. Im Patentanspruch 4 der DE-PS 34 04 976 wird weiterhin vorgeschlagen, bei zweistelligen Werten für die Programmnummer jeder möglichen Dezimalstelle eine eigene Kennung zuzuordnen. Dies bewirkt, daß bei höheren einstelligen Programmnummern die Umschaltung auf das gewünschte Programm unmittelbar nach Betätigung der zugehörigen Zifferntaste erfolgt, da anhand der abgespeicherten Kennung sofort erkannt wird, daß bei Betätigung der genannten Zifferntaste eine einstellige Programmnummer gewünscht wird. Ferner wird im Patentanspruch 9 der DE-PS 34 04 976 vorgeschlagen, bei gewünschter einstelliger Programmnummer vor Betätigung der zugehörigen Zifferntaste die Taste "Null" zu betätigen. Dadurch wird das Zeitglied abgeschaltet, so daß die Umschaltung auf das der gewünschten einstelligen Programmnummer zugeordnete Programm unmittelbar nach Betätigung der die Programmnummer spezifizierenden Zifferntaste erfolgt. Zusammenfassend betrachtet bietet die in der DE-PS 34 04 976 beschriebene Anordnung den Vorteil, daß die Bedientastatur keine Dezimaltasten benötigt.

Die Aufgabe der Erfindung besteht darin, die im Oberbegriff des Patentanspruchs angegebene Anordnung derart weiterzubilden, daß die Umschaltung auf das gewünschte Programm stets verzögerungsfrei erfolgt.

Diese Aufgabe wid bei einer Anordnung der im Oberbegriff des Patentanspruchs angegebenen Art durch die im kennzeichnenden Teil des Patentanspruchs angegebenen Merkmale gelöst.

Die Vorteile der Erfindung bestehen darin, daß die beanspruchte Anordnung keine Dezimaltasten benötigt und daß die Umschaltung auf das gewünschte Programm auch bei einstelligen Programmnummern stets unmittelbar nach Betätigung der letzten das Programm spezifizierenden Zifferntaste erfolgt. Insbesondere sind hierzu keine benutzerseitigen Maßnahmen (Eingabe der "Null" vor der einstelligen Programmnummer) und kein Speicherplatz zur Abspeicherung einer Dezimalkennung notwendig.

Nachfolgend wird die Erfindung anhand eines Ausführungsbeispiels näher beschrieben.

Es sei davon ausgegangen, daß ein Fernsehempfänger die Möglichkeit bietet, 49 Fernsehprogramme abzuspeichern und unter Verwendung der Zifferntasten eines Fernbedienungsgebers auf ein gewünschtes Programm einbzw. umzuschalten.

Die Programmanwahl einer einstelligen Programmnummer geschieht wie folgt: Nach Betätigung der entsprechenden Zifferntaste auf dem Fernbedienungsgeber schaltet die Steuereinheit des Fernsehempfängers, der ein für die Zifferntaste charakteristisches elektrisches Signal zugeführt wird, den Fernsehempfänger ohne jede Verzögerung auf das durch die Zifferntaste bezeichnete Programm um. Gleichzeitig beginnt ein durch ein Zeitglied bestimmtes Zeitintervall zu laufen. Dies kann dem Benutzer beispielsweise durch eine blinkende Anzeige der eingegebenen Ziffer auf einem Display am Fernsehempfänger selbst oder auf dem Fernbedienungsgeber signalisiert werden. Da jedoch durch die genannte Zifferntaste das gewünschte Programm bereits vollständig spezifiziert und unmittelbar nach der Betätigung der Zifferntaste auf das gewünschte Programm umgeschaltet wurde, hat das Laufen des durch das Zeitglied bestimmten Zeitintervalles keinerlei Einfluß auf die Programmumschaltung.

Die Programmanwahl einer zweistelligen Programmnummer geschieht wie folgt: Nach Betätigung der ersten Zifferntaste der zweistelligen Programmnummer schaltet die Steuereinheit den Fernsehempfänger ohne Verzögerung auf das durch die erste Zifferntaste bezeichnete Programm um. Gleichzeitig beginnt das durch das Zeitglied bestimmte Zeitintervall zu laufen. Wird nun während dieses Zeitintervalles eine zweite Zifferntaste betätigt, so erkennt die Steuereinheit, daß eine zweistellige Programmnummer gewünscht wird und schaltet den Fernsehempfänger unmittelbar nach Betätigung der zweiten Zifferntaste auf das gewünschte, durch die zweistellige Programmnummer spezifizierte Programm um.

Durch die vorstehend beschriebene Anordnung wird demzufolge erreicht, daß die Umschaltung auf das gewünschte Programm sowohl bei einstelligen als auch bei zweistelligen Programmnummern unmittelbar nach der Eingabe der letzten das Programm spezifizierenden Zifferntaste erfolgt, d.h. bei einstelligen Programmnummern unmittelbar nach Betätigung der zugehörigen einzigen Zifferntaste und bei zweistelligen Programmnummern unmittelbar nach Betätigung der zweiten Zifferntaste.

## Patentansprüche

1. Anordnung zur Programmanwahl bei Empfangsgeräten der Unterhaltungselektronik mit
   – einer Zehnertastatur zur Eingabe der das gewünschte Programm spezifizierenden Programmnummer,
   – einer Steuereinheit zur Auswertung der eingegebenen Programmnummer und zur Umschaltung des Empfangsgerätes auf das gewünschte Programm in Ansprache auf die eingegebene Programmnummer, und
   – einem Zeitglied zur Festlegung eines Zeitintervalles, welches bei Betätigung einer ersten Zifferntaste der Zehnertastatur zu laufen beginnt,
   wobei die Steuereinheit auf ein Programm mit einer zweistelligen Programmnummer unmittelbar nach der während des genannten Zeitintervalles erfolgenden Eingabe der zweiten Ziffer der zweistelligen Programmnummer umschaltet, **dadurch gekennzeichnet**, daß die Steuereinheit das Empfangsgerät auf ein Programm mit einer einstelligen Programmnummer unmittelbar nach Betätigung der der Programmnummer zugeordneten Zifferntaste umschaltet.

## Claims

1. Arrangement for programme selection in consumer electronics receivers, having
   – a numeric keyboard for entering the programme number specifying the desired programme,
   – a control unit for evaluating the entered programme number and for switching the receiver over to the desired programme in accordance with the entered programme number, and
   – a timer for defining a time interval which starts to run on operation of a first numeric key of the numeric keyboard,
   the control unit switching over to a programme having a two-digit programme number immediately after the second digit of the two-digit programme number has been entered during the said time interval, characterised in that the control unit switches the receiver over to a programme having a single-digit programme number immediately after operating the numeric key associated with the programme number.

## Revendications

1. Dispositif de sélection de programmes dans des appareils récepteurs de l'électronique du spectacle, comportant
   – un clavier décimal pour introduire le numéro de programme spécifiant le programme désiré,
   – une unité de commande pour évaluer le numéro de programme introduit et commuter l'appareil récepteur sur le programme désiré en réponse au numéro de programme introduit, et
   – une minuterie pour fixer un intervalle de temps qui commence à s'écouler lors de l'actionnement d'une première touche à chiffre du clavier décimal,
   l'unité de commande étant commutée sur un programme possédant un numéro de programme à deux chiffres, directement après l'introduction, exécutée pendant ledit intervalle de temps, du second chiffre du numéro de programme à deux chiffres,
   caractérisé en ce que l'unité de commande commute l'appareil récepteur sur un programme possédant un numéro de programme à un chiffre, juste après l'actionnement de la touche à chiffre associée au numéro du programme.